# EUROPÄISCHE PATENTSCHRIFT

(11) **EP 1 805 354 B1**
(45) Veröffentlichungstag und Bekanntmachung des Hinweises auf die Patenterteilung: **28.07.2010**
(21) Anmeldenummer: 05797973.4
(22) Anmeldetag: 04.10.2005
(51) Int. Cl.: C30B 29/40, C30B 19/02, C30B 17/00, C30B 9/00

(54) **VERFAHREN ZUR HERSTELLUNG VON GRUPPE-III-NITRID- VOLUMENKRISTALLEN ODER -KRISTALLSCHICHTEN AUS METALLSCHMELZEN**
METHOD FOR THE PRODUCTION OF GROUP III NITRIDE BULK CRYSTALS OR CRYSTAL LAYERS FROM FUSED METALS
PROCEDE DE PRODUCTION DE COUCHES DE CRISTAL OU CRISTAUX MASSIFS DE NITRURE DU GROUPE III A PARTIR DE BAINS FONDUS

(30) Priorität: 05.10.2004 DE 102004048454
(43) Veröffentlichungstag der Anmeldung: 11.07.2007
(73) Patentinhaber: Fraunhofer-Gesellschaft zur Förderung der angewandten Forschung e.V., 80686 München (DE)
(72) Erfinder: FRIEDRICH, Jochen, 90542 Eckental (DE); MÜLLER, Georg, 91094 Landensendlbach (DE); APELT, Rainer, 91365 Weilersbach (DE); MEISSNER, Elke, 90542 Eckental (DE); BIRKMANN, Bernhard, 63755 Alzenau (DE); HUSSY, Stephan, 90419 Nürnberg (DE)
(74) Vertreter: Gagel, Roland
(86) Internationale Anmeldenummer: PCT/DE2005/001771
(87) Internationale Veröffentlichungsnummer: WO 2006/037310

(56) Entgegenhaltungen:
- WO-A-03/035945
- US-A1- 2004 124 434
- US-B1- 6 562 124
- PATENT ABSTRACTS OF JAPAN Bd. 1997, Nr. 09, 30. September 1997 (1997-09-30) & JP 09 134878 A (MATSUSHITA ELECTRON CORP), 20. Mai 1997 (1997-05-20)
- KLEMENZ C ET AL: "Crystal growth and liquid-phase epitaxy of gallium nitride" JOURNAL OF CRYSTAL GROWTH, ELSEVIER, AMSTERDAM, NL, Bd. 211, Nr. 1-4, April 2000 (2000-04), Seiten 62-67, XP004193350 ISSN: 0022-0248
- KAWAMURA F ET AL: "GROWTH OF A LARGE GAN SINGLE CRYSTAL USING THE LIQUID PHASE EPITAXY (LPE) TECHNIQUE" JAPANESE JOURNAL OF APPLIED PHYSICS, JAPAN SOCIETY OF APPLIED PHYSICS, TOKYO, JP, Bd. 42, Nr. 1A/B, PART 2, 15. Januar 2003 (2003-01-15), Seiten L04-L06, XP001191978 ISSN: 0021-4922

## Beschreibung

### Technisches Anwendungsgebiet

Die vorliegende Erfindung betrifft ein Verfahren zur Herstellung von Gruppe-III-Nitrid-Volumenkristallen oder -Kristallschichten auf einem Gruppe-III-Nitrid-Kristallkeim oder auf einem Fremdsubstrat durch Abscheidung aus einer Gruppe III-haltigen Metallschmelze. Das Verfahren ermöglicht die Herstellung von Gruppe III-Nitrid-Substraten mit einer Fläche von mehr als 100 mm² und von Gruppe III-Nitrid-Volumenkristallen mit einem Durchmesser > 10 mm, bei Versetzungsdichten ≤ 10⁸ cm⁻² und bei Verfahrensdrücken < 5 x 10⁵ Pa. Das erfindungsgemäße Verfahren findet in erster Linie im Bereich der Optoelektronik, der Kommunikationstechnologie und der Hochfrequenztechnik bei der Herstellung von Halbleiter- und Verbindungshalbleiter-Bauelementen basierend auf dem III-V Materialsystem Anwendung.

### Stand der Technik

Halbleiter und Verbindungshalbleiter auf Nitridbasis stellen ein industriell noch relativ wenig genutztes Materialsystem dar. Galliumnitrid (GaN) ist ein Halbleiter mit großem direktem Bandabstand (3,4 eV). Mit seinen Homologen Aluminiumnitrid (AlN, Bandabstand 6,3 eV) und Indiumnitrid (InN, Bandabstand 1,9 eV) bildet es ternäre Mischkristalle, wodurch sich der Spektralbereich von 6,3 eV - 1,9 eV überspannen lässt.

Damit die materialspezifischen Vorteile von Gruppe-III-Nitrid-basierten Bauelementen voll ausgenutzt werden können, müssen die Bauelemente auf Substraten abgeschieden werden, die die gleiche Längenausdehnung und Gitterparameter wie die Gruppe-III-Nitrid-Kristalle selbst haben. Iso-strukturelle Gruppe-III-Nitrid-Substrate eignen sich daher für die Herstellung von Gruppe III-Nitrid-basierten Bauelementen ebenso, wie reine Gruppe-III-Nitrid-Substrate.

Eine wesentliche Schwierigkeit für die Herstellung von Gruppe-III-Nitrid-basierten Bauelementen ist die Tatsache, dass zur Zeit für eine industrielle Massenproduktion nicht in ausreichender Menge und Qualität Gruppe-III-Nitrid-Substrate zur Verfügung stehen, um darauf homoepitaktisch Bauelemente abzuscheiden. Die Gruppe-III-Nitrid-Bauelemente werden daher auf nicht angepassten Fremdsubstraten abgeschieden, vor allem Saphir und Siliziumcarbid, mit entsprechenden Nachteilen für die Leistungsfähigkeit und Lebensdauer der damit hergestellten Bauelemente. Zur Abscheidung der Gruppe-III-Nitrid-Bauelemente auf die Substrate kommt dabei heute insbesondere das Metal Organic Vapour Phase Epitaxy (MOVPE) Verfahren zur Anwendung.

Die bisher zur Herstellung von Gruppe-III-Nitrid-Substraten bzw. -Volumenkristallen eingesetzten Techniken sind im Wesentlichen Gasphasenprozesse, d. h. die notwendigen Komponenten werden als metallorganische, anorganische oder metallische Ausgangssubstanzen zur Verfügung gestellt und in aufwendigen Reaktoren unter Zugabe von Wasserstoff, Ammoniak und Chlorwasserstoff bei hohen Temperaturen (1100°C) zu gasförmigen Reaktanden und schließlich zu Gruppe-III-Nitriden umgesetzt.

Dabei hat sich für die Herstellung von GaN-Substraten insbesondere das Hydride-Vapor-Phase-Epitaxy (HVPE) - Verfahren, wegen der damit erzielbaren hohen Qualität der GaN Kristallschichten und der hohen Wachstumsraten von bis zu 100 µm/h, als geeignet erwiesen. Bei dem HVPE-Verfahren, strömt Chlorwasserstoff über flüssiges Gallium, das sich typischerweise auf Temperaturen zwischen 800 - 900°C befindet. Dabei entstehen Galliumchlorid und Wasserstoff. Durch die Reaktion des gasförmigen Galliumchlorids mit Ammoniak, der separat in den Reaktor eingelassen wird, findet sich das Galliumnitrid gemäß der Gleichung GaCl + NH₃ -> GaN + H₂ + HCl in der Reaktionszone auf einem Fremdsubstrat. Die Machbarkeit der Herstellung von dünnen und dicken Galliumnitrid-Schichten mit 5 cm Durchmesser bzw. von Galliumnitrid-Volumenkristallen mit 5 cm Durchmesser ist für das HVPE-Verfahren bereits demonstriert worden.

Bekannt sind darüber hinaus Verfahren zur Sublimationszüchtung (Sandwich Sublimation Technique, SST), zur Hochdruck-Lösungszüchtung (High Pressure Solution Growth, HPSG) und zur Ammonothermalen Züchtung (Ammonothermal Growth Technique, AGT) von GaN-Kristallen bzw. -Kristallschichten. Diese Verfahren sind aufwendig und erfordern teilweise einen hohen gerätetechnischen Aufwand. Bisher gelang es mit dem Hochdrucklösungszüchtungsverfahren GaN-Kristallschichten mit einer Dicke von 100 µm und lateralen Dimensionen von etwa 1cm herzustellen.

Klemenz et al. (J. Crystal Growth 211 (2000) SS 62-67) offenbaren ein LPE (Flüssige Phasen-Epitaxie) Lösungszüchtungsverfahren zur Herstellung von Kristallschichten aus Gruppe III-Nitrid.

Nach dem Stand der Technik ist jedoch das HVPE-Verfahren das einzige Verfahren, das GaN Substrate in gewissen Mengen für die Herstellung von Demonstrator-Bauelementen zur Verfügung stellen kann. Für eine industrielle Produktion sind jedoch die mit dem HVPE-Verfahren erzielbaren Mengen und die Qualität, vor allem die Größe der GaN-Substrate nicht ausreichend. Darüber hinaus ist der technische Aufwand und die damit zusammenhängenden Kosten für das HVPE-Verfahren sehr hoch.

Die bisher bekannten Anwendungen der Lösungszüchtung von Gruppe-III-Nitrid-Substraten aus flüssigen

Metallschmelzen, haben dagegen zu keinen, mit dem HVPE-Verfahren vergleichbaren Ergebnissen geführt.

### Darstellung der Erfindung

Der Erfindung liegt die Aufgabe zugrunde, ein industriell einsetzbares Produktionsverfahren anzugeben, mit welchem Gruppe-III-Nitride entweder als Schichtkristalle oder als Volumenkristalle mit einem Durchmesser > 10 mm, mit Versetzungsdichten ≤ 10⁸ cm⁻², bei Verfahrensdrücken < 5 x 10⁵ Pa und Temperaturen ≤ 1100°C hergestellt werden können.

Die Aufgabe wird mit dem Verfahren gemäß dem Patentanspruch 1 gelöst. Den Erfindungsgedanken vorteilhafte weiterbildende Merkmale sind Gegenstand der Unteransprüche sowie der Beschreibung, insbesondere unter Bezugnahme auf das Ausführungsbeispiel.

Das erfindungsgemäße Verfahren zur Herstellung von Kristallschichten oder Volumenkristallen aus Gruppe-III-Nitrid oder aus Mischungen verschiedener Gruppe-III-Nitride durch Abscheidung aus einer Gruppe-III-haltigen Metallschmelze bei einer ersten Temperatur in einem ersten Temperaturbereich, auf einem in die Metallschmelze eingebrachten Gruppe-III-Nitrid Kristallkeim oder auf einem Fremdsubstrat, mit einem Stickstoffeintrag in die Metallschmelze bei einem Druck P, zeichnet sich dadurch aus, dass der Metallschmelze ein Lösungsmittelzusatz, der den Umsatz von Gruppe III Metall zu Gruppe III Nitrid in der Metallschmelze erhöht, zugegeben wird. Darüber hinaus durchläuft die Metallschmelze zumindest einen Temperaturzyklus mit einer ersten und einer zweiten Phase, in dem die Metallschmelze nach Ende der ersten Phase von der ersten Temperatur T₁ auf eine zweite Temperatur T₂ unterhalb des ersten Temperaturbereiches gekühlt und am Ende der zweiten Phase von der zweiten Temperatur wieder auf eine Temperatur T₃ im ersten Temperaturbereich erwärmt wird.

Die Auswahl des ersten Temperaturbereichs und damit die Temperaturen T₁ und T₃ sowie die Temperaturerniedrigung zwischen T₁ und T₂ und damit die Auswahl der Temperatur T₂ hängen von der Wahl des Gruppe-III Metalls, des Lösungsmittelszusatzes und dessen Konzentration in der Metallschmelze, der Art des Stickstoffeintrags in die Metallschmelze und dem Prozessdruck ab.

Bei dem erfindungsgemäßen Verfahren handelt es sich um ein Lösungszüchtungsverfahren (Liquid Phase Epitaxy, LPE), oder genauer, um ein Niederdruck-Lösungszüchtungsverfahren (Low Pressure Solution Growth, LPSG).

Für die Herstellung der Gruppe-III-Metallschmelze werden vorzugsweise die Elemente Aluminium, Gallium und Indium verwendet.

Bei Lösungszüchtungs-Verfahren zur Herstellung von Gruppe-III-Nitrid-Kristallen wird die Abscheiderate der Gruppe-III-Nitrid-Kristalle auf den Kristallkeim oder das Substrat wesentlich vom Umsatz des Gruppe-III-Metalls zu Gruppe-III-Nitrid in der Metallschmelze bestimmt. Reine Gruppe-III-Metallschmelzen weisen bei geeigneter Stickstoffzufuhr in die Metallschmelze jedoch nur einen geringen Umsatz von Gruppe-III-Metall zu Gruppe-III-Nitrid auf.

Bei dem erfindungsgemäßen Verfahren wird zumindest ein Lösungsmittelzusatz in der Gruppe-III-haltigen Metallschmelze verwendet, welcher diesen Umsatz erhöht und eine kontrollierte Kristallisation von Gruppe III-Nitriden ermöglichen.

Als Lösungsmittelzusatz wird insbesondere zumindest ein Element der Elemente C, Si, Ge, Fe, Sn, Bi, Cr, Ni, Zn, Pb, und/ oder zumindest ein Element der seltenen Erden oder eine Legierung, oder eine Verbindung dieser Elemente, insbesondere ihrer Nitride der Gruppe-III-haltigen Metallschmelze zugegeben.

Bei dem erfindungsgemäßen Verfahren wird die Metallschmelze vor Beginn einer ersten Prozessphase auf eine geeignete erste Temperatur T₁, in einem ersten Temperaturbereich zwischen 800°C und 1100°C erhitzt. In dieser ersten Prozessphase findet eine Abscheidung von Gruppe-III-Nitrid-Kristallen auf die in die Metallschmelze eingebrachten Substrate oder Kristallkeime, und somit Kristallwachstum statt. Die erste Temperatur T₁ sowie die weiteren Prozessparameter, wie beispielsweise die Prozessdrücke und der gasförmige oder feststoffliche Eintrag von Stickstoff in die Metallschmelze, werden während der ersten Prozessphase vorzugsweise konstant gehalten.

Die erste Prozessphase wird durch Abkühlung der Metallschmelze auf eine zweite Temperatur T₂ unterhalb des ersten Temperaturbereichs, beendet und in eine zweite Prozessphase überführt. Die Temperaturerniedrigung von T₁ auf T₂ beträgt dabei mindestens 30 K. Die Temperaturerniedrigung bewirkt in der zweiten Prozessphase ein stark vermindertes oder gestopptes Kristallwachstum und verhindert das bekannte Emporkriechen der Metallschmelze aus deren Behältnis.

In der zweiten Phase kann zusätzlich der Stickstoffeintrag in die Metallschmelze reduziert oder gestoppt werden. Damit werden die beschriebenen Effekte verstärkt.

Die zweite Prozessphase beginnt mit dem Abkühlen der Metallschmelze von der ersten Temperatur T₁ auf die zweite Temperatur T₂ und wird nach dem anschließenden Erhitzen der Metallschmelze auf eine Temperatur T₃ innerhalb des ersten Temperaturbereichs beendet. Sobald die zweite Temperatur T₂ erreicht ist, kann grundsätzlich bereits die Erwärmung auf eine Temperatur T₃ erfolgen. Vorteilhaft ist jedoch eine Haltezeit von 1 min bis zu mehreren Stunden auf der Temperatur T₂.

Nach der Erhitzung der Metallschmelze auf die Temperatur T₃ wird eine weitere erste Prozessphase an diese zweite Prozessphase angeschlossen. Die Temperatur T₃ kann, muss aber nicht identisch mit der Temperatur T₁ sein. Wesentlich für das weitere Kristallwachstum ist jedoch, dass T₃ innerhalb des ersten Temperaturbereichs liegt.

Überraschenderweise hat sich gezeigt, dass diese weitere erste Prozessphase bis in die Größenordnung von 100 Stunden ausgedehnt werden kann und dabei ein Kristallwachstum möglich ist, ohne dass wesentliche parasitäre Ablagerungen entstehen oder ein Emporkriechen der Metallschmelze an den Wänden des Metallschmelzenbehälters auftritt.

Wird der erfindungsgemäße Temperaturzyklus fortgesetzt, d.h. folgen abwechselnd eine erste und eine zweite Prozessphase aufeinander, so können in den dadurch entstehenden Kristallschichten Versetzungsdichten von deutlich unter 10⁸ cm² erreicht werden. Zudem sind sehr lange Gesamtprozessdauern möglich, wobei Kristalle oder Substrate mit der gewünschten Größe erzeugt werden können.

Auf Grund des gestoppten oder stark verminderten Kristallwachstums während der zweiten Prozessphase und dem weiteren Kristallwachstum bei Fortsetzung des erfindungsgemäßen Temperaturzyklus, entstehen in den abgeschiedenen Kristallen Grenzflächen oder Grenzschichten, die sich mit mikroskopischen Methoden nachweisen lassen. Dies führt dazu, dass sich Gruppe-III-Nitrid-Volumenkristalle oder -Substrate, die nach diesem Verfahren hergestellt werden, nachträglich eindeutig erkennen lassen.

Der Stickstoffeintrag in die Metallschmelze erfolgt bei dem erfindungsgemäßen Verfahren unter Verwendung eines reaktiven stickstoffhaltigen, insbesondere festen oder gasförmigen Stoffes, vorzugsweise Galliumnitrid (GaN), Ammoniak (NH₃) oder Hydrazin (H₂N-NH₂), und einem stickstoffhaltigen (N₂) Trägergas, insbesondere einer Mischung aus Stickstoff (N₂) und Wasserstoff (H₂).

Eine vorteilhafte Weiterbildung des Verfahrens verbessert den Transport von Stickstoff in der Metallschmelze darüber hinaus durch Erzeugen einer Konvektion in der Metallschmelze, beispielsweise durch mechanisches Rühren oder mit Hilfe von Magnetfeldern. Dadurch wird die Transportrate des eingebrachten Stickstoffs durch die Oberfläche der Metallschmelze hindurch in die Metallschmelze hinein erhöht, was zu einer weiteren Erhöhung des Umsatzes von Ga zu GaN beiträgt. Damit wird die Abscheiderate von GaN auf dem Kristallkeim aus der Metallschmelze erhöht.

### Kurze Beschreibung der Zeichnungen

Die Erfindung wird nachstehend ohne Beschränkung des allgemeinen Erfindungsgedankens anhand eines Ausführungsbeispiels unter Bezugnahme auf die Zeichnungen exemplarisch beschrieben. Es zeigen:
- Fig. 1: schematisierte Darstellung des Modellreaktors,
- Fig. 2: Temperaturzyklen des erfindungsgemäßen Verfahrens, und
- Fig. 3: Aufnahme eines Transmissionselektronen- mikroskops: Querschnitt durch eine mit dem erfindungsgemäßen Verfahren auf ein Substrat aufgebrachte GaN Kristall- schicht.

### Wege zur Ausführung der Erfindung

Das erfindungsgemäße Verfahren wird nachfolgend exemplarisch am Beispiel der Herstellung von GaN-Kristallschichten dargestellt.

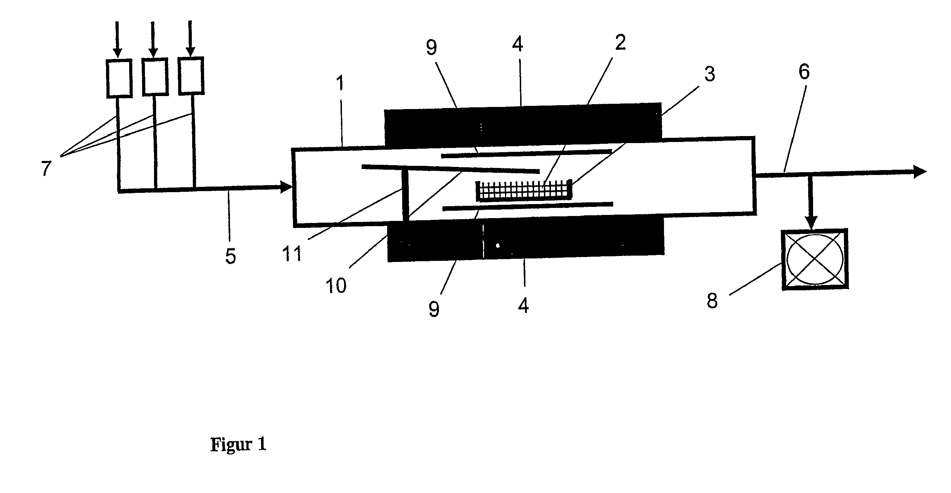

In Figur 1 wird ein Modellreaktor schematisch dargestellt, mit dem das nachfolgend beschriebene Ausführungsbeispiel durchgeführt wird.

Der Modellreaktor besteht aus einer verschließbaren, hitzebeständigen Quarzglasampulle 1, die in Richtung ihrer Längsachse außen von einem Rohrofen 4 umschlossen wird. Die Quarzglasampulle 1 enthält aus Reinheitsgründen im heißen Bereich keine Bauteile aus Graphit und insbesondere kein Quarzglas, das in Kontakt mit der Metallschmelze stehen. Der Rohrofen 4 ist ein horizontal aufgestellter widerstandsbeheizter Ofen, mit einer Heizzone. Die Verwendung vertikal aufgestellter Induktiv- oder Strahlungsbeheizter Öfen mit mehreren Heizzonen oder von Öfen mit anderen Möglichkeiten der Wärmezufuhr ist ebenfalls möglich. Die Metallschmelze 2 befindet sich in einem Tiegel 3 aus Bornitrid innerhalb der Quarzglasampulle 1. Der Tiegel 3 ist auf einem Quarzglasliner 9 innerhalb der Quarzglasampulle 1 angeordnet. In der Quarzglasampulle 1 befindet sich eine Keimstange 10, an der ein Kristallisationskeim anbringbar ist. Die Keimstange kann über eine Mechanik 11 derart betätigt werden, dass ein Ende der Keimstange 10, an dem der Kristallisationskeim befestigt ist, in die Metallschmelze 2 getaucht und auch aus ihr entfernt werden kann. Die Quarzglasampulle 1 weist eine Gaszuführung 5 für das Einströmen des Trägergases und des Stickstoffhaltigen reaktiven, gasförmigen Stoffes, sowie eine Abluftabführung 6 auf. Die Gaszuführung 5 ist so gestaltet, dass der Gaseintritt nahe der Oberfläche der Metallschmelze 2 erfolgt. Die Abluftführung 6 ist mit einer Turbomolekularpumpe 8 verbunden, mit der die Quarzglasampulle evakuiert werden kann.

Zu Beginn des Verfahrens wird in dem gereinigten Tiegel 3 Ga und als Lösungsmittelzusatz Ge eingebracht. Die Reinheit von Ga und Ge ist besser als 5N. Als Kristallisationskeim wird ein Gruppe-III-Nitrid-Kristall verwendet.

Zu Prozessbeginn wird zunächst eine Reinigungsphase durchlaufen. Dabei wird die Quarzglasampulle 1 auf einen Druck < 1 Pa evakuiert und dabei die Metallschmelze auf 500°C bis 600°C erhitzt. Nach Erreichen von stabilen Temperaturbedingungen werden diese für mindestens eine Stunde gehalten, wobei der Quarzglasampulle 1 nun ein Gasgemisch aus Stickstoff (N₂) und Wasserstoff (H₂) zugeführt wird. Die Reinigungsphase endet sobald der Tiegel 3 auf die erste Temperatur T₁ von 950°C geheizt ist. Der an einer Keimstange 10 befestigte Kristallisationskeim wird in die Metallschmelze 2 eingetaucht. Zusätzlich zum Trägergas (N₂ und H₂) wird nach Erreichen der Temperatur T₁ Ammoniak (NH₃) in die Quarzglasampulle 1 eingeleitet. Das Mischungsverhältnis der Gase wird über die Massenflussregler 7 gesteuert. Der Ammoniakfluss wird dabei so eingestellt, dass er dem Gleichgewichtspartialdruck nahe kommt. Durch das Einleiten des Ammoniaks erfolgt ein Stickstoffeintrag an der Oberfläche der Metallschmelze. Der Umsatz von Ga zu GaN wird durch das in der Metallschmelze enthaltene Ge signifikant erhöht.

Am Ende der ca. 10 Stunden dauernden ersten Prozessphase (Kristallwachstumsphase), wird zu Beginn der zweiten Prozessphase die Temperatur der Metallschmelze von T₁ = 950 °C auf die zweite Temperatur T₂ = 800°C abgesenkt. Dadurch wird ein Kriechen der Metallschmelze aus dem Tiegel verhindert. Das Kristallwachstum kommt in der zweiten Prozessphase zum Stillstand. Nach einer Haltezeit von einer Stunde auf der zweiten Temperatur T₂ = 800 °C, wird die Metallschmelze auf die Temperatur T₃ = 950 °C erhitzt. Damit schließt sich an die zweite Prozessphase eine weitere 10 Stunden dauernde erste Prozessphase mit Kristallwachstum an.

In dem Ausführungsbeispiel werden die Temperaturen T₁ und T₃ mit 950 °C identisch gewählt. Desweiteren wird die Zufuhr des Trägergases und von Ammoniak während der ersten und zweiten Prozessphase unverändert beibehalten. Der Temperaturzyklus wird durch Abwechseln jeweils einer ersten und einer zweiten Prozessphase so lange fortgesetzt, bis Kristalle oder Kristallschichten der gewünschten Größenordnung entstanden sind.

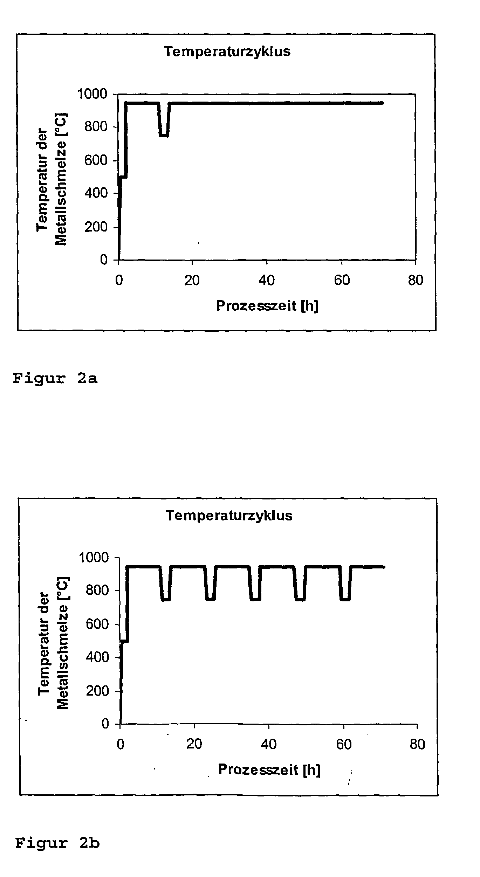

In den Figuren 2a und 2b sind schematisiert zwei erfindungsgemäße Temperaturzyklen dargestellt. Dabei ist jeweils die Temperatur der Metallschmelze über der Zeitachse aufgetragen.

In Figur 2a wird ein kompletter Temperaturzyklus, bestehend aus einer ersten und einer zweiten Prozessphase durchlaufen. Anschließend wird nur noch eine weitere erste Prozessphase angeschlossen. Diese kann ein Vielfaches der Dauer der anfänglichen ersten Prozessphase haben.

In Figur 2b werden mehrere komplette Temperaturzyklen bestehend aus erster und zweiter Prozessphase durchlaufen. Das Aneinanderreihen von erster und zweiter Prozessphase wird solange wiederholt, bis ein GaN-Kristall bzw. eine GaN-Kristallschicht mit der gewünschten Dimension gewachsen ist.

Sowohl in Figur 2a als auch in Figur 2b sind zu Beginn der jeweiligen Prozesse Reinigungsphasen, wie bereits beschrieben, vorgeschaltet.

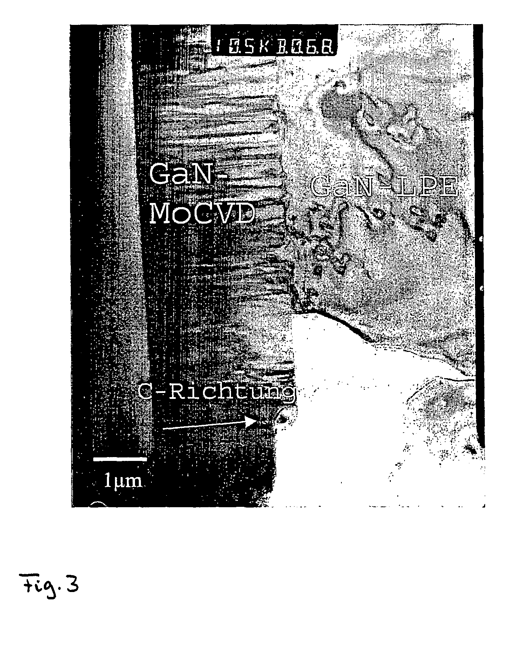

In Figur 3 ist eine Aufnahme eines Transmissionselektronenmikroskops (TEM) gezeigt. Die Aufnahme gibt einen Querschnitt durch mehrere Kristallschichten eines GaN-Substrats wieder. Es sind drei Bereiche (Schichten) zu erkennen. Ein homogener Bereich links zeigt das Fremdsubstrat. Darauf wurde zunächst mittels metallorganischer chemischer Gasphasenabscheidung (Metal Organic Chemical Vapour Deposition, MOCVD) eine GaN Kristallschicht aufgebracht. Diese mittlere Kristallschicht zeigt senkrecht zur Oberfläche des Grundsubstrats verlaufende längliche Strukturen, die Versetzungen in der Kristallstruktur darstellen und damit auf hohe Versetzungsdichten in dieser Schicht hinweisen. Auf diese Kristallschicht wurde mit dem erfindungsgemäßen Verfahren der Lösungszüchtung (Liquid Phase Epitaxy, LPE) eine weitere GaN-Kristallschicht aufgebracht (rechter Bereich). Deutlich zu erkennen ist, dass sich die Bereiche hoher Versetzungsdichten (längliche Strukturen) in der mittleren Kristallschicht nicht in die rechte Kristallschicht hinein fortsetzen, sondern, dass die nach dem erfindungsgemäßen Verfahren erzeugte GaN-Kristallschicht sich im TEM Bild durch einen wenig strukturierten Bereich und damit durch deutlich geringere Versetzungsdichten auszeichnet.

Der wesentliche Vorteil des Verfahrens gegenüber den bekannten Verfahren liegt:
- in der längeren Gesamtprozessdauer durch Verhindern des Emporkriechens der Metallschmelze aus deren Behälter,
- in der damit möglichen Herstellung von Gruppe-III-Nitrid-Substraten mit einer Fläche von mehr als 100 mm² und von Gruppe III-Nitrid-Massivkristallen mit einem Durchmesser von > 10 mm bei Versetzungsdichten ≤ 10⁸ cm⁻², bei Verfahrensdrücken < 5 x 10⁵ Pa,
- in deutlich reduzierten Anlagen- und Prozesskosten zur Herstellung von Gruppe III-Nitrid-Substraten oder - Massivkristallen und
- in dem relativ einfachen up-scaling des Verfahrens für eine industrielle Produktion von Gruppe-III-Nitrid-Kristallen oder -Substraten.

### Bezugszeichenliste

- 1: Quarzglasampulle
- 2: Probe einer Gruppe III Metallschmelze mit Lösungsmittelzusatz
- 3: Tiegel
- 4: Rohrofen
- 5: Gaszuleitung
- 6: Abluftableitung
- 7: Massenflussregler
- 8: Turbomolekularpumpe
- 9: Quarzglasliner
- 10: Keimstange
- 11: Mechanik zum Eintauchen der Keimstange in die Metallschmelze

## Patentansprüche

1. Verfahren zur Herstellung von Kristallschichten oder Volumenkristallen aus Gruppe-III-Nitrid oder aus Mischungen verschiedener Gruppe-III-Nitride durch Abscheidung aus einer Gruppe-III-haltigen Metallschmelze bei einer ersten Temperatur in einem ersten Temperaturbereich, auf einem in die Metallschmelze eingebrachten Gruppe-III-Nitrid-Kristallkeim oder auf einem Fremdsubstrat, mit einem Stickstoffeintrag in die Metallschmelze bei einem Druck P, wobei der Metallschmelze ein Lösungsmittelzusatz, der den Umsatz von Gruppe III Metall zu Gruppe-III-Nitrid in der Metallschmelze erhöht, zugegeben wird, die Metallschmelze zumindest einen Temperaturzyklus mit einer ersten und einer zweiten Prozessphase durchläuft, in dem die Metallschmelze nach Ende der ersten Prozessphase von der ersten Temperatur T₁ auf eine zweite Temperatur T₂ unterhalb des ersten Temperaturbereichs gekühlt und am Ende der zweiten Prozessphase von der zweiten wieder auf eine Temperatur innerhalb des ersten Temperaturbereichs erwärmt wird.

2. Verfahren nach Anspruch 1,
**dadurch gekennzeichnet, dass** der Stickstoffeintrag in die Metallschmelze bei Drücken unter 5 x 10⁵ Pa erfolgt.

3. Verfahren nach einem der Ansprüche 1 oder 2,
**dadurch gekennzeichnet, dass** die Obergrenze des ersten Temperaturbereichs ≤ 1100°C beträgt.

4. Verfahren nach einem der Ansprüche 1 bis 3,
**dadurch gekennzeichnet, dass** für den Stickstoffeintrag in die Metallschmelze ein Gas oder ein Gasgemisch verwendet wird.

5. Verfahren nach Anspruch 4,
**dadurch gekennzeichnet, dass** für den Stickstoffeintrag in die Metallschmelze ein Gasgemisch verwendet wird,
das aus einem Trägergas und einem reaktiven stickstoffhaltigen Stoff besteht.

6. Verfahren nach Anspruch 5,
**dadurch gekennzeichnet, dass** als Trägergas ein Gemisch aus Stickstoff (N₂) und Wasserstoff (H₂), und als reaktiver stickstoffhaltiger Stoff Ammoniak (NH₃) oder Hydrazin (H₂N-NH₂)verwendet wird.

7. Verfahren nach einem der Ansprüche 1 bis 3,
**dadurch gekennzeichnet, dass** für den Stickstoffeintrag in die Metallschmelze ein Feststoff oder ein Feststoffgemisch verwendet wird.

8. Verfahren nach Anspruch 7,
**dadurch gekennzeichnet, dass** für den Stickstoffeintrag in die Metallschmelze GaN verwendet wird.

9. Verfahren nach einem der Ansprüche 1 bis 8,
**dadurch gekennzeichnet, dass** die Reinheit der verwendeten Gase und Feststoffe besser als 5N ist.

10. Verfahren nach einem der Ansprüche 5 bis 6,
**dadurch gekennzeichnet, dass** der Partialdruck des reaktiven stickstoffhaltigen gasförmigen Stoffes in Abhängigkeit von der Zusammensetzung des Gasgemisches, der Oberflächentemperatur der Metallschmelze und dem Lösungsmittelzusatz kontrolliert und angepasst wird.

11. Verfahren nach einem der Ansprüche 1 bis 10,
**dadurch gekennzeichnet, dass** eine Reinigungsphase vorgesehen ist, bei der ein sich über der Metallschmelze befindendes begrenztes Volumen evakuiert, die Metallschmelze erhitzt und anschließend das begrenzte Volumen über der Metallschmelze mit einem Gasgemisch, insbesondere Stickstoff (N₂) und Wasserstoff (H₂) durchströmt wird.

12. Verfahren nach Anspruch 11,
**dadurch gekennzeichnet, dass** die Reinigungsphase zumindest eine Minute aufrecht erhalten wird und bei Temperaturen der Metallschmelze zwischen 500 bis 600°C erfolgt.

13. Verfahren nach einem der Ansprüche 1 bis 12,
**dadurch gekennzeichnet, dass** die erste Prozessphase über einen Zeitraum von mindestens 1 Stunde aufrecht erhalten wird.

14. Verfahren nach einem der Ansprüche 1 bis 13,
**dadurch gekennzeichnet, dass** die zweite Temperatur T₂ mindestens 30 K unterhalb der ersten Temperatur T₁ liegt.

15. Verfahren nach einem der Ansprüche 1 bis 14,
**dadurch gekennzeichnet, dass** in der Metallschmelze eine Konvektion erzeugt wird, insbesondere durch einen Temperaturgradienten in der Metallschmelze, oder durch mechanisches Rühren oder mit Hilfe von Magnetfeldern, um die Transportrate des Stickstoffes durch die Metallschmelze zum wachsenden Kristall hin zu erhöhen,

16. Verfahren nach einem der Ansprüche 1 bis 15,
**dadurch gekennzeichnet, dass** ein Gruppe-III-Metall sowie ein Lösungsmittelzusatz verwendet wird, deren Reinheit besser als 5N ist.

17. Verfahren nach einem der Ansprüche 1 bis 16,
**dadurch gekennzeichnet, dass** der Gruppe-III-Nitrid-Kristallkeim oder das Fremdsubstrat an einer Halterung befestigt ist und damit in die Metallschmelze eingetaucht wird.

18. Verfahren nach Anspruch 17,
**dadurch gekennzeichnet, dass** die Halterung mit dem daran befestigten Gruppe-III-Nitrid Kristallkeim oder dem Fremdsubstrat vertikale, horizontale oder rotatorische Bewegungen oder Überlagerungen dieser Bewegungen in der Metallschmelze ausführt.

19. Verfahren nach einem der Ansprüche 1 bis 18,
**dadurch gekennzeichnet, dass** als Fremdsubstrat Saphir, Siliziumcarbid, Silizium, Aluminiumnitrid, Galliumarsenid oder ein Oxidkristall mit oder ohne darauf aufgebrachter Gruppe-III-Nitridschicht eingesetzt wird.

20. Verfahren einem der nach Ansprüche 1 bis 19,
**dadurch gekennzeichnet, dass** die zweite Temperatur T₂ und/ oder der Stickstoffeintrag in die Metallschmelze in der zweiten Prozessphase so eingestellt werden, dass die Abscheidung von Gruppe-III-Nitrid aus der Gruppe-III-haltigen Metallschmelze auf einen Kristallkeim oder ein Substrat stark vermindert ist oder zum Stillstand kommt.

21. Verfahren nach einem der Ansprüche 1 bis 20,
**dadurch gekennzeichnet, dass** kein Graphit verwendet wird und die Metallschmelze keinen direkten Kontakt mit Quarzglas hat.

## Claims

1. A method for producing crystal layers or bulk crystals of group III nitride or of mixtures of different group III nitrides by deposition from group III-containing fused metal at a first temperature in a first temperature range onto a group III nitride seed crystal introduced into the fused metal or onto a foreign substrate, with introduction of nitrogen into the fused metal at a pressure P, a solvent being added to the fused metal, which increases the conversion of group III metal to group III nitride in the fused metal, the fused metal being run through at least one temperature cycle with a first and a second process phase, in which the fused metal is cooled after the end of the first process phase from the first temperature T₁ to a second temperature T₂ below the first temperature range and at the end of the second process phase heated again from the second temperature to a temperature within the first temperature range.

2. A method according to claim 1,
**characterized in that** the introduction of nitrogen into the fused metal occurs at pressures below 5 x 10⁵ Pa.

3. A method according to any of claims 1 or 2,
**characterized in that** the upper limit of the first temperature range is ≤ 1100°C.

4. A method according to any of claims 1 to 3,
**characterized in that** a gas or a gas mixture is used for the introduction of nitrogen into the fused metal.

5. A method according to claim 4,
**characterized in that** a gas mixture comprising a carrier gas and a reactive nitrogen-containing substance is used for the introduction of nitrogen into the fused metal.

6. A method according to claim 5,
**characterized in that** a mixture of nitrogen (N₂) and hydrogen (H₂) is used as carrier gas, and ammonia (NH₃) or hydrazine (H₂N-NH₂) is used as reactive nitrogen-containing substance.

7. A method according to any of claims 1 to 3,
**characterized in that** a solid or a mixture of solids is used for the introduction of nitrogen into the fused metal.

8. A method according to claim 7,
**characterized in that** GaN is used for the introduction of nitrogen into the fused metal.

9. A method according to any of claims 1 to 8,
**characterized in that** the purity of the used gases and solids is better than 5N.

10. A method according to any of claims 5 to 6,
**characterized in that** the partial pressure of the reactive nitrogen-containing gaseous substance is controlled and adjusted depending on the composition of the gas mixture, the surface temperature of the fused metal and the added solvent.

11. A method according to any of claims 1 to 10,
**characterized in that** a purification phase is included, in which a limited volume located above the fused metal is evacuated, the fused metal is heated, and subsequently a gas mixture, in particular nitrogen (N₂) and hydrogen (H₂), is passed through the limited volume above the fused metal.

12. A method according to claim 11,
**characterized in that** the purification phase is maintained for at least one minute and occurs at temperatures of the fused metal between 500 to 600 °C.

13. A method according to any of claims 1 to 12,
**characterized in that** the first process phase is maintained over a time period of at least one hour.

14. A method according to any of claims 1 to 13,
**characterized in that** the second temperature T₂ is at least 30 K below the first temperature T₁.

15. A method according to any of claims 1 to 14,
**characterized in that** convection is produced in the fused metal, in particular by means of a temperature gradient within the fused metal, or by mechanical stirring or with the help of magnetic fields, in order to increase the transport rate of nitrogen through the fused metal in the direction of the growing crystal.

16. A method according to any of claims 1 to 15,
**characterized in that** a group III metal and an added solvent is used, the purity of which is better than 5N.

17. A method according to any of claims 1 to 16,
**characterized in that** the group III nitride seed crystal or the foreign substrate is attached to a holder and is immersed in the fused metal with it.

18. A method according to claim 17,
**characterized in that** the holder with the attached group III nitride seed crystal or the foreign substrate performs vertical, horizontal or rotatory motions or superimpositions of these motions in the fused metal.

19. A method according to any of claims 1 to 18,
**characterized in that** sapphire, silicon carbide, silicon, aluminum nitride, gallium arsenide or an oxide crystal with or without a group III nitride layer applied to it is used as foreign substrate.

20. A method according to any of claims 1 to 19,
**characterized in that** the second temperature T₂ and/or the introduction of nitrogen into the fused metal in the second phase are adjusted in such a way that the deposition of group III nitride from the group III-containing fused metal onto a seed crystal or a substrate is greatly reduced or comes to a standstill.

21. A method according to any of claims 1 to 20,
**characterized in that** graphite is not used and the fused metal has no direct contact with quartz glass.

## Revendications

1. Procédé de préparation de couches cristallines ou de cristaux volumineux constitués de nitrure de groupe III ou de mélanges de différents nitrures de groupe III, réalisée par dépôt, à partir d'un métal en fusion, sur un germe de cristallisation en nitrure de groupe III qui est introduit dans ledit métal en fusion ou sur un substrat étranger, ledit métal en fusion contenant du groupe III et ayant une première température située dans une première gamme de températures, de l'azote étant introduit, à une pression P, dans ledit métal en fusion et un solvant étant ajouté audit métal en fusion afin de favoriser, au sein du métal en fusion, la transformation de métal de groupe III en nitrure de groupe III, ledit métal en fusion subissant au moins un cycle thermique avec une première et une deuxième phases de procédé, ledit métal en fusion étant, au terme de ladite première phase de procédé, refroidi d'une première température T₁ à une deuxième température T₂ qui est inférieure à ladite première gamme de températures et, au terme de ladite deuxième phase de procédé, réchauffé à une température située dans ladite première gamme de températures.

2. Procédé selon la revendication 1,
**caractérisé en ce que** l'introduction d'azote dans ledit métal en fusion est réalisée à des pressions inférieures à 5 x 10⁵ Pa.

3. Procédé selon l'une des revendications 1 ou 2,
**caractérisé en ce que** la limite supérieure de ladite première gamme de température est de ≤ 1100 °C.

4. Procédé selon l'une des revendications 1 à 3,
**caractérisé en ce que**, pour réaliser l'introduction d'azote dans ledit métal en fusion, on utilise un gaz ou un mélange de gaz.

5. Procédé selon la revendication 4,
**caractérisé en ce que**, pour réaliser l'introduction d'azote dans ledit métal en fusion, on utilise un mélange de gaz constitué d'un gaz vecteur et d'un composé réactif contenant de l'azote.

6. Procédé selon la revendication 5,
**caractérisé en ce que** l'on utilise, en tant que gaz vecteur, un mélange d'azote (N₂) et d'hydrogène (H₂) et, en tant que composé réactif contenant de l'azote, de l'ammoniac (NH₃) ou de l'hydrazine (H₂N-NH₂).

7. Procédé selon l'une des revendications 1 à 3,
**caractérisé en ce que**, pour réaliser l'introduction d'azote dans ledit métal en fusion, on utilise une matière solide ou un mélange de matières solides.

8. Procédé selon la revendication 7,
**caractérisé en ce que**, pour réaliser l'introduction d'azote dans ledit métal en fusion, on utilise du GaN.

9. Procédé selon l'une des revendications 1 à 8,
**caractérisé en ce que** la pureté des gaz et matières solides utilisés est supérieure à 5N.

10. Procédé selon l'une des revendications 5 à 6, **caractérisé en ce que** la pression partielle du composé gazeux contenant de l'azote est contrôlée et ajustée en fonction de la composition dudit mélange de gaz, de la température de surface du métal en fusion et du solvant ajouté.

11. Procédé selon l'une des revendications 1 à 10,
**caractérisé en ce qu'**au moins une phase de purification est prévue dans laquelle un volume confiné se trouvant en-dessus dudit métal en fusion est évacué pour ensuite chauffer le métal en fusion puis faire passer un débit d'un mélange de gaz, notamment d'azote (N₂) et d'hydrogène (H₂), à travers ledit volume confiné en-dessus du métal en fusion.

12. Procédé selon la revendication 11,
**caractérisé en ce que** ladite phase de purification est maintenue pendant au moins une minute et qu'elle est réalisée alors que la température dudit métal en fusion est comprise entre 500 et 600 °C.

13. Procédé selon l'une des revendications 1 à 12,
**caractérisé en ce que** ladite première phase de procédé est maintenue pour une période d'au moins 1 heure.

14. Procédé selon l'une des revendications 1 à 13,
**caractérisé en ce que** ladite deuxième température T₂ est inférieure d'au moins 30 K à ladite première température T₁.

15. Procédé selon l'une des revendications 1 à 14,
**caractérisé en ce que**, au sein dudit métal en fusion, une convection est mise en oeuvre, notamment au moyen d'un gradient de température au sein du métal en fusion, ou par agitation mécanique ou à l'aide de champs magnétiques, pour ainsi augmenter de taux de transport dudit azote à travers le métal en fusion en direction du cristal en croissance.

16. Procédé selon l'une des revendications 1 à 15,
**caractérisé en ce que** l'on utilise un métal de groupe III ainsi qu'un solvant ajouté dont la pureté est supérieure à 5N.

17. Procédé selon l'une des revendications 1 à 16,
**caractérisé en ce que** ledit germe de cristallisation de nitrure de groupe III ou ledit substrat étranger sont fixés sur un support avec lequel ils sont immergés dans ledit métal en fusion.

18. Procédé selon la revendication 17,
**caractérisé en ce que** ledit support sur lequel sont fixés ledit germe de cristallisation de nitrure de groupe III ou ledit substrat étranger est soumis, au dudit métal en fusion, à des mouvements verticaux, horizontaux ou rotatoires ou à des superpositions desdits mouvements.

19. Procédé selon l'une des revendications 1 à 18,
**caractérisé en ce que** l'on utilise, en tant que substrat étranger, du saphir, du carbure de silicium, du silicium, du nitrure d'aluminium, de l'arséniure de gallium ou un cristal d'oxyde avec ou sans dépôt d'une couche de nitrure de groupe III.

20. Procédé selon l'une des revendications 1 à 19,
**caractérisé en ce que** ladite deuxième température T₂ et/ou ladite introduction d'azote dans ledit métal en fusion pendant la deuxième phase de procédé sont ajustés de manière à fortement réduire ou arrêter le dépôt de nitrure de groupe III, à partir dudit métal en fusion contenant du groupe III, sur un germe de cristallisation ou un substrat.

21. Procédé selon l'une des revendications 1 à 20,
**caractérisé en ce que** l'on n'utilise pas de graphite et que ledit métal en fusion n'est pas en contact direct avec du verre de quartz.
